# EUROPÄISCHE PATENTSCHRIFT

(11) **EP 2 479 894 B1**
(45) Veröffentlichungstag und Bekanntmachung des Hinweises auf die Patenterteilung: **03.07.2019**
(21) Anmeldenummer: 11151497.2
(22) Anmeldetag: 20.01.2011
(51) Int. Cl.: H03K 17/96

(54) **Kapazitive Taste**
Capacitative button
Touche capacitive

(43) Veröffentlichungstag der Anmeldung: 25.07.2012
(73) Patentinhaber: RAFI GmbH & Co. KG, 88276 Berg (DE)
(72) Erfinder: Koch, Werner, 88276 Berg (DE); Sitnikov, Eugen, 88213 Ravensburg (DE)
(74) Vertreter: Engelhardt, Volker

(56) Entgegenhaltungen:
- EP-A2- 1 253 717
- US-A- 4 845 421
- US-A1- 2006 015 284

## Beschreibung

Die Erfindung bezieht sich auf eine kapazitive Taste nach dem Oberbegriff des Patentanspruches 1.

Solche kapazitiven Tasten, die beispielsweise aus der US 2006/015284 A1, der EP 1 253 717 A2 oder der US 4,845,421 A bekannt geworden sind, dienen als Bedienelement für elektrische Geräte, beispielsweise Herdplatten, Kaffeeautomaten oder medizintechnische Gerätschaften. Die einzelnen kapazitiven Tasten wandeln eine manuelle Betätigung in ein elektrisches Schaltsignal um, in dem das von der Taste ausgesandte Kapazitätsfeld durch das Eindringen eines menschlichen Fingers bzw. eines elektrisch leitenden Objekts auf definiertem Potential verändert wird. Diese Kapazitätsveränderungen können durch die Auswerteeinrichtung erfasst werden, so dass von dieser bei entsprechender Kapazitätsveränderung das Schaltsignal erzeugt ist. Solche Tasten ermöglichen beispielsweise das Ein- und Ausschalten der elektrischen Geräte.

Die jeweiligen Schaltsensoren sind mit einer Leiterplatte oder mit der Auswerteeinrichtung elektrisch verbunden und werden von dieser mit Strom versorgt und gleichzeitig permanent überwacht, sobald der Schaltsensor aktiviert ist, um die Kapazitätsveränderungen zu erfassen.

Oftmals dienen Abdeckplatten, insbesondere aus Glas oder aus einem anderen transparenten nicht leitenden Werkstoff, als Begrenzung und bilden demnach eine Schaltfläche, die von dem menschlichen Finger oder dem elektrisch leitenden Objekt berührt wird. Durch die transparente Eigenschaft der Abdeckplatte ist gewährleistet, dass darunter Leuchtdioden mit Symbolen und dergleichen angeordnet werden können, um die Bedienfunktion der jeweiligen kapazitiven Taste zu visualisieren. Das von dem Schaltsensor erzeugte elektrische Feld weist eine räumliche Ausdehnung auf und tritt durch die elektrisch nicht leitfähige Abdeckplatte, ohne von dieser abgelenkt zu werden, hindurch, so dass ein elektrisches Feld auf der Außenseite der Abdeckplatte im Bereich der Schaltfläche vorhanden ist. Sobald ein Fremdkörper, beispielsweise ein menschlicher Finger, in das elektrische Feld eindringt, wird die Kapazitätsveränderung von dem Schaltsensor erfasst und an die Auswerteeinrichtung weitergegeben, so dass von dieser das elektrische Schaltsignal erzeugt wird.

Als nachteilig bei solchen kapazitiven Tastern hat sich nunmehr herausgestellt, dass auch unbeabsichtigte Schaltvorgänge entstehen, wenn beispielsweise ein Feuchtigkeitsfilm bestehend aus einer Vielzahl von Wassertropfen in den Bereich des Schaltsensors auf der Abdeckplatte gelangen. Durch den Wasserfilm wird nämlich ebenso eine Kapazitätsveränderung erreicht, die von der Auswerteeinrichtung erfasst ist. Die Auswerteeinrichtung kann demnach nicht unterscheiden, ob die Kapazitätsveränderung durch ein bewusstes und korrektes Eindringen eines menschlichen Fingers oder von einem Wassertropfen bzw. einem Wasserfilm hervorgerufen wurde.

Da solche elektrischen Geräte, beispielsweise als Dampfgarer in Küchen eingebaut sind, in deren Umgebung oftmals eine hohe Luftfeuchtigkeit herrscht, entstehen insbesondere an den gegenüber der Umgebungstemperatur kalten Abdeckplatte Wasserkondensationen, die zu derartigen Wassertropfen auf den Abdeckplatten führen und durch die somit die Schaltfunktion des kapazitiven Tasters in Form von Fehlfunktionen beeinträchtigt ist.

Es ist daher Aufgabe der Erfindung, einen kapazitiven Taster der eingangs genannten Gattung derart weiterzubilden, dass durch die Auswerteeinrichtung zuverlässig ermittelbar ist, ob die Funktion des Tasters bewusst und gewollt ausgeübt ist oder ob eine Fehlfunktion bspw. durch einen Wasserfilm entstanden ist. Zusätzlich soll ermöglicht sein, dass durch den kapazitiven Taster und dessen Auswerteeinrichtung, die Bewegung bzw. die Aktivierung des kapazitiven Tasters in Bezug auf eine sich eingestellte Bewegungsrichtung erfolgt.

Diese Aufgaben sind erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass der Schaltsensor von mindestens einem Referenzsensor ganz oder teilweise ummantelt ist und der Referenzsensor ein eigenständiges elektrisches Feld ausbildet, kann durch die Auswerteeinrichtung erfasst werden, ob beispielsweise ein Wassertropfen von außen nach innen, also in Richtung des Schaltsensors, läuft. Sollte also der Referenzsensor eine Veränderung des elektrischen Feldes erfassen, kann durch die Auswerteeinrichtung die Schaltfunktion des Schaltsensors gesperrt oder freigegeben sein. Die Bewegung des menschlichen Fingers in Richtung des Schaltsensors erfolgt üblicherweise senkrecht von oben zu diesem, so dass feststellbar ist, ob seitliche Bewegungen in Richtung auf den Schaltsensor zulaufen oder nicht. In Abhängigkeit von dieser Auswertung kann durch die Auswerteeinrichtung der Schaltsensor aktiviert oder gesperrt sein.

Es ist besonders vorteilhaft, wenn mehrere Referenzsensoren kaskadenförmig um den Schaltsensor angeordnet sind und wenn die Breite der jeweiligen Referenzsensoren unterschiedlich groß bemessen ist, denn dadurch kann auch die Geschwindigkeit und die Bewegungsrichtung einer Kapazitätsveränderung erfasst werden. Sobald nämlich eine Kapazitätsveränderung eines der Referenzsensoren durch die Auswerteeinrichtung festgestellt ist, ist verifizierbar, ob die Bewegungsrichtung auf den Schaltsensor zuläuft bzw. welche Geschwindigkeit diese Bewegung aufweist. In Abhängigkeit von diesen ermittelbaren Messdaten kann durch die Auswerteeinrichtung der Schaltsensor freigegeben oder gesperrt werden. Aufgrund von unterschiedlichen Breiten der Sensoren wird deren Empfindlichkeit auf das Eindringen eines Fremdkörpers in das elektrische Feld erhöht. Die Messgenauigkeit des Referenzsensors kann außerdem in der Auswerteeinrichtung mittels Software erfolgen.

In der Zeichnung ist ein erfindungsgemäßes Ausführungsbeispiel eines kapazitiven Tasters mit verschiedenartig ausgestalteten Schalt- und Referenzsensoren dargestellt, die nachfolgend näher erläutert sind. Im Einzelnen zeigt:
- Figur 1: einen kapazitiven Taster mit einer Leiterplatte, auf der ein rechteckförmiger Schaltsensor und sieben den Schaltsensor ummantelnde Referenzsensoren aufgebracht sind, die unabhängig voneinander ein elektrisches Feld auf der Außenseite einer Abdeckplatte erzeugen und deren Kapazitätsveränderung mittels einer Auswerteeinrichtung zur Erzeugung eines elektrischen Schaltsignales erfassbar ist, im Schnitt,
- Figur 2: die kapazitive Taste gemäß Figur 1 in Draufsicht, mit einem Finger und dessen Bewegungsrichtung,
- Figur 3: die kapazitive Taste gemäß Figur 1 mit einem auf der Abdeckplatte verlaufenden Wasserfilm, im Schnitt,
- Figur 4a: die kapazitive Taste gemäß Figur 1 in Draufsicht mit einer den Schaltsensor vollständig umschließenden Anordnung von vier Referenzsensoren,
- Figur 4b: die kapazitive Taste gemäß Figur 1 in Draufsicht mit einem runden Schaltsensor und zentrisch um diesen umlaufenden Referenzsensoren und
- Figur 4c: die kapazitive Taste gemäß Figur 4b mit Referenzsensoren, die voneinander getrennt und derart aufgebaut sind, dass eine Bewegungsrichtung auswertbar ist.

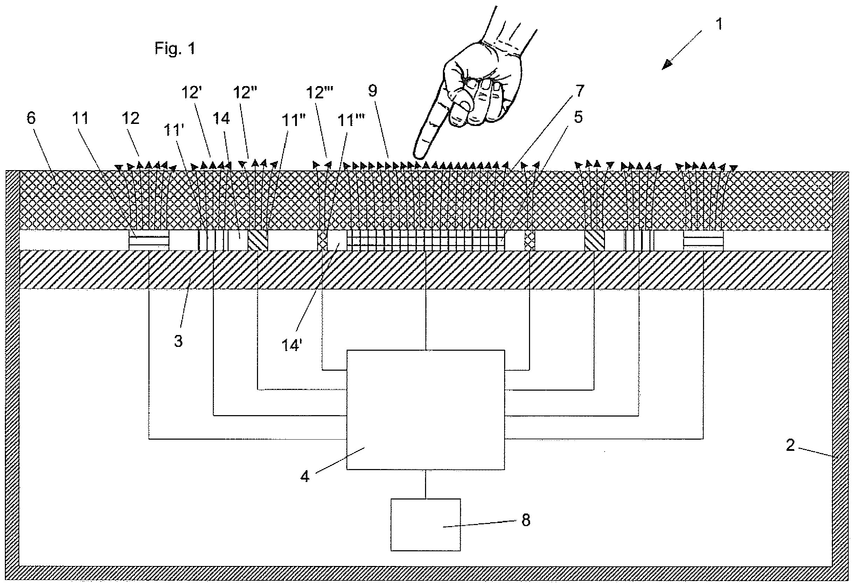

In Figur 1 ist eine kapazitive Taste 1 zur Erzeugung eines elektrisch auswertbaren Schaltsignals abgebildet, die aus einem Gehäuse 2 und einer Abdeckplatte 6 aus Glas oder einem anderen transparenten oder elektrisch nicht leitenden Werkstoff besteht. In das Gehäuse 2 ist eine Aussparung eingearbeitet, in die die Abdeckplatte 6 bündig mit der Außenseite des Gehäuses 2 eingesetzt ist.

Des Weiteren ist an dem Gehäuse 2 eine Leiterplatte 3 angeordnet, die elektrisch mit einer Auswerteeinrichtung 4 und einer Spannungsversorgung 8 verbunden ist. Auf der Leiterplatte 3, und zwar auf der der Abdeckplatte 6 zugewandten Oberseite, ist ein Schaltsensor 5 angebracht. Der Schaltsensor 5 ist als Schaltfläche ausgestaltet und bildet, sobald dieser bestromt ist, ein elektrisches Feld 9 aus, das in Richtung der Abdeckplatte 6 räumlich abstrahlt. Der Schaltsensor 5 ist dabei derart dimensioniert, dass das elektrische Feld 9 auf der nach außen abstehenden Außenseite der Abdeckplatte 6 verläuft und somit in diesem Bereich eine Schaltfläche 7 gebildet ist. Sobald der Finger einer menschlichen Hand oder ein elektrisch leitendes Objekt in das elektrische Feld 9 eindringt, verändert sich der Wert des Kapazität innerhalb des elektrischen Feldes 9. Diese Kapazitätsveränderung wird von der als integrierten Schaltkreis ausgestalteten Auswerteeinrichtung erfasst und weitergeleitet, so dass durch diese ein elektrisches Schaltsignal generiert ist, durch das beispielsweise ein elektrisches Gerät, vorzugsweise ein Dampfgarer oder eine Herdplatte, ein- oder ausgeschaltet ist.

Der Schaltsensor 5 kann auch an der der Leiterplatte 3 zugewandten Innenseite der Abdeckplatte 6 befestigt und elektrisch mit der Auswerteeinrichtung 4 verbunden sein.

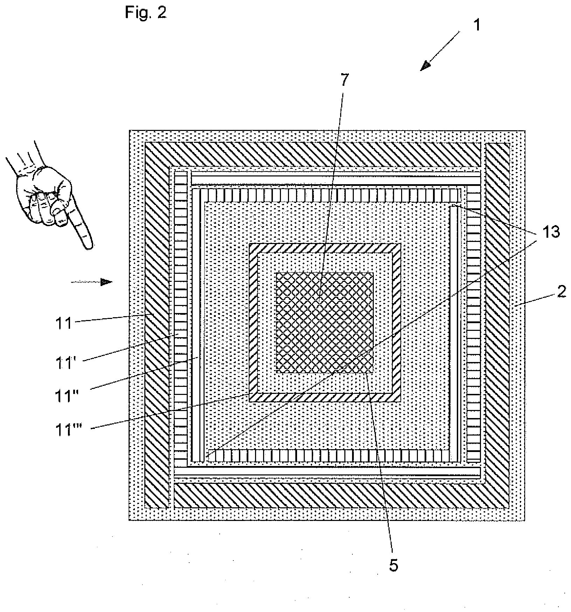

Bei solchen elektrischen Geräten entstehen, insbesondere während der Betriebszeiten, durch Kondensation oder sonstige Luftfeuchtigkeiten Wassertropfen oder Wasserfilme 16, die sich auf die Schaltfläche 7 legen können. Der Auswerteeinrichtung 4 erkennt dann nicht mehr, ob es sich um den Finger einer menschlichen Hand, also um die gewollte und bewusste Betätigung handelt oder ob durch den Wasserfilm 16 eine ungewollte Aktivierung der Auswerteeinrichtung 4 erfolgt ist. Um eine solche Fehlfunktion zu vermeiden, sind, und dies ist insbesondere der Figur 2 zu entnehmen, drei Paare von als integrierte Schaltkreise ausgestaltete Referenzsensoren 11, 11' und 11" um den Schaltsensor 5 angeordnet, der folglich im Zentrum der Referenzsensoren 11, 11', 11" positioniert ist. Der Schaltsensor 5 weist eine rechteckförmige, vorzugsweise quadratische Außenkontur auf und die Außen- und Innenkonturen der jeweiligen Referenzsensoren 11, 11' und 11" sind an die Außenkonturen des Schaltsensors 5 derart angepasst, dass der jeweilige Referenzsensor 11, 11', 11" und 11'" einen konstanten Abstand um den Schaltsensor aufweist.

Den Schaltsensor 5 umschließen drei Paare von Referenzsensoren 11, 11', 11" und 11'", die derart ausgestaltet sind, dass eine Bewegungsrichtung eines Fingers bzw. eines leitenden Objekts auf definiertem Potential ausgewertet werden kann. Diese drei Paare von Referenzsensoren 11', 11", 11'" werden hauptsächlich für eine Bewegungserkennung verwendet, liefern aber auch die Information, ob Wasser bzw. Wasserdampf vorhanden ist. Der Referenzsensor 11'" umschließt den Schaltsensor komplett und befindet sich in unmittelbarer Nähe von diesen. Dieser Referenzsensor wird für Wassererkennung verwendet. Der Schaltsensor 5 kann alle denkbaren geometrischen Ausgestaltungen aufweisen. Dies richtet sich nach der gewünschten Funktion bzw. Gesamtaufbau des Geräts. Der innerste Referenzsensor ist 11'". Sowohl zwischen dem Schaltsensor 5 und den innersten Referenzsensoren 11'" als auch zwischen den Paaren von Referenzsensoren 11, 11' und 11" sind Freiräume 14 vorgesehen, so dass die Referenzsensoren 11, 11' und 11" voneinander und zu dem Schaltsensor 5 beabstandet sind.

Zudem ist die Breite der Referenzsensoren 11, 11', 11" und 11'" unterschiedlich groß bemessen, so dass die von den Referenzsensoren 11, 11', 11" und 11"' gebildeten elektrischen Felder 12, 12', 12" und 12'" unterschiedlich breit bemessen sind. Jeder der Referenzsensoren 11, 11', 11" und 11'" ist elektrisch mit der Auswerteeinrichtung 4 verbunden, um ein eigenständiges elektrisches Feld 12, 12', 12" und 12'" zu bilden, so dass durch die Auswerteeinrichtung 4 feststellbar ist, wann und ob sich das elektrische Feld 12, 12', 12" oder 12"' der jeweiligen Referenzsensoren 11, 11', 11" und 11"' verändert.

Aufgrund der Kapazitätsveränderung innerhalb des elektrischen Feldes 12, 12', 12" und 12'" der Referenzsensoren 11, 11', 11" und 11'" kann demnach festgestellt werden, ob beispielsweise der Finger einer menschlichen Hand von außen nach innen in einer bestimmten Geschwindigkeit in Richtung des Schaltsensors 5 bewegt ist. Da die Bewegung eines menschlichen Fingers entlang einer Oberfläche, also der Abdeckplatte 6, in einem bestimmten Geschwindigkeitsbereich liegt, kann durch diese Auswertung festgestellt werden, ob die Bewegung tatsächlich von dem Finger einer menschlichen Hand durchgeführt ist oder ob beispielsweise ein langsam fließender bzw. herunterlaufender Wasserfilm 16 auf der Abdeckplatte 6 vorhanden ist.

Die Unterscheidung einer gewollten Betätigung der kapazitiven Taste 1 von einer unbeabsichtigten Auslösung durch Wasser wird anhand zweier Parameter gemacht. Zum einen ist die Geschwindigkeit und zum anderen ist die Stärke der Feldbeeinflussung unterschiedlich.

Durch die Veränderungen der elektrischen Felder 12, 12', 12" und 12"' kann demnach von der Auswerteeinrichtung 4 erfasst werden, ob sich ein Wasserfilm 16 oder Finger einer menschlichen Hand in Richtung auf den Schaltsensor 5 und die Schaltfläche 7 zubewegt und in Abhängigkeit von diesen Messdaten kann die Auswerteeinrichtung 4 die Eingabe über den Schaltsensor 5 aktivieren oder sperren. Folglich ist hierdurch verhindert, dass der Schaltsensor 5 ungewollt durch einen Wasserfilm 16 aktiviert ist.

Aus Figur 2 ist zudem ersichtlich, dass die Paare von Referenzsensoren 11, 11' bzw. 11" an zwei Positionen 13, die diagonal gegenüberliegend angeordnet sind, voneinander getrennt sind. Somit umschließen zwei Referenzsensoren 11, 11' und 11" jeweils paarweise die Schaltfläche 5 bzw. ummanteln die innenliegenden Referenzsensoren 11' und 11". Dadurch ist gewährleistet, dass die Messempfindlichkeit erhöht ist, denn durch die Auswerteeinrichtung ist nunmehr feststellbar, in weichem Teilbereich eines der Referenzsensoren 11, 11', 11" oder 11'" eine Bewegung stattfindet und dass diese Bewegung zielgerichtet auf die Schaltfläche 7 in einer bestimmten Geschwindigkeit zuläuft oder ob beispielsweise die Bewegung eines Wasserfilms 16 diagonal über die Abdeckplatte 6 erfolgt. Auch aus diesen Messdaten kann somit durch die Auswerteeinrichtung 4 erfasst sein, ob es sich um eine gewollte Bewegung eines menschlichen Fingers oder um das Vorhandensein eines Wasserfilms 16 handelt, durch den die Eingabe über den Schaltsensor 5 nicht aktiviert werden soll.

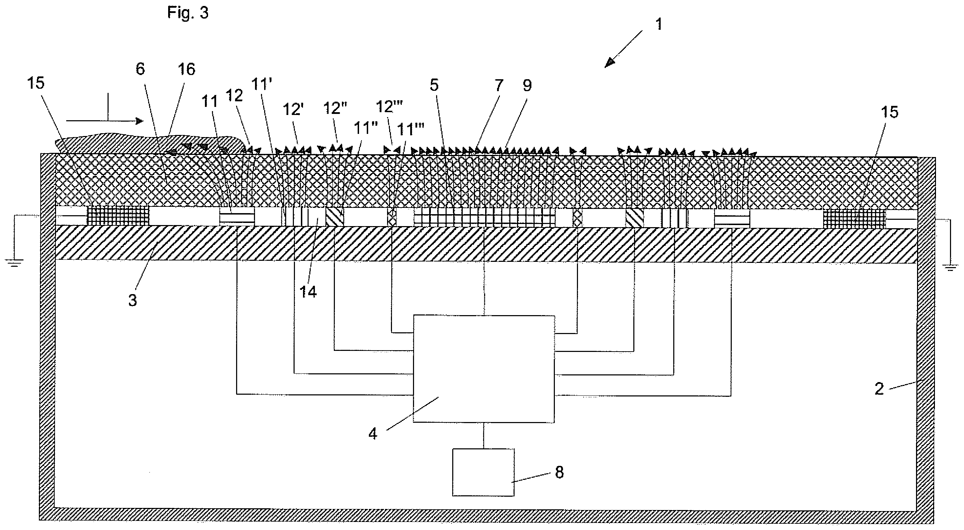

In Figur 3 ist die kapazitive Taste 1 der Figur 1 derart weitergebildet, dass im äußeren Bereich des Gehäuses 2 ein Metallring 15 vorgesehen ist, durch den der äußere Referenzsensor 11 vollständig ummantelt ist. Wenn daher von außen ein Wasserfilm 16 sowohl den Metallring 15 als auch den äußersten Referenzsensor 11 abdeckt, wird das elektrische Feld 12 in Richtung des Metallringes 15 ausgelenkt. Mit Hilfe des Metallringes 15 können daher weitere Fehlfunktionen vermieden sein, denn sobald eine solche Ablenkung des elektrischen Feldes 12 stattfindet, erfasst diese Ablenkung die Auswerteeinrichtung 4, so dass unmittelbar feststellbar ist, dass ein Wasserfilm 16 auf der Abdeckplatte 6 vorhanden ist.

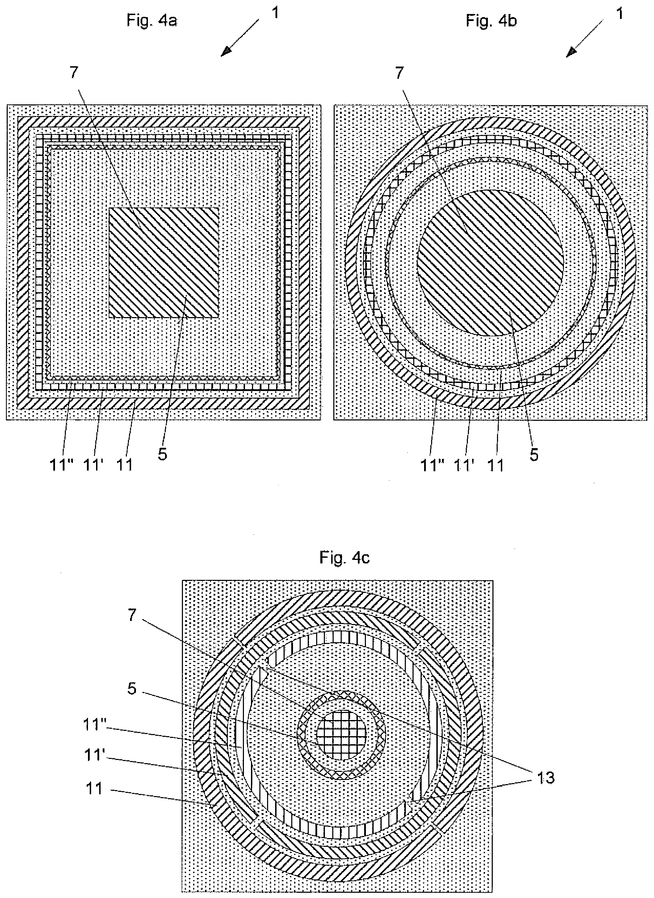

In den Figuren 4a, 4b und 4c sind Variationen von konstruktiven Ausbildungen des Schaltsensors 5 und der Referenzsensoren 11, 11', 11" und 11'" dargestellt. In Figur 4a sind die Referenzsensoren 11, 11' und 11" rechteckförmig und vollständig geschlossen um den innenliegenden Schaltsensor 5 angeordnet.

In Figur 4b ist gezeigt, dass sowohl der Schaltsensor 5 als auch die jeweiligen Referenzsensoren 11, 11' und 11" rund ausgestaltet sein können und in Figur 4c ist jeder der Referenzsensoren 11, 11' und 11" abschnittsweise getrennt, so dass zwischen zwei auf einer gemeinsamen Kreisbahn um den Schaltsensor 5 angeordneten Referenzsensoren 11, 11' und 11" ein Freiraum 13 vorhanden ist. Durch diese konstruktive Maßnahme wird die Messgenauigkeit der Referenzsensoren 11, 11' und 11" erhöht.

## Patentansprüche

1. Kapazitive Taste (1) zur Erzeugung eines elektrisch auswertbaren Schaltsignals,
- mit einer Abdeckplatte (6), die insbesondere aus Glas oder einem elektrisch nicht leitenden Werkstoff besteht und durch die eine von außen zugängliche Schaltfläche (7) gebildet ist,
- mit einem auf einer Träger- oder Leiterplatte (3) angeordneten oder auf der der Schaltfläche (7) gegenüberliegenden Innenseite der Abdeckplatte (6) angebrachten und bestromten Schaltsensor (5), durch den ein auf der Schaltfläche (7) der Abdeckplatte (6) wirkendes elektrisches Feld (9) erzeugt wird,
- mit einer Auswerteeinrichtung (4), die elektrisch mit dem Schaltsensor (5) zur Erkennung der Veränderungen der Kapazität innerhalb des elektrischen Feldes (9) auf der Schaltfläche (7) verbunden ist,
- mit mindestens einem den Schaltsensor (5) ganz oder teilweise ummantelnden Referenzsensoren (11, 11' ... 11ⁿ), der bestromt ist und der zu dem Außenumfang des Schaltsensors (5) vorgegebenen Abstand aufweist, und durch den oder die jeweils eine eigenständige Kapazität innerhalb eines elektrischen Feldes (12, 12' ... 12ⁿ) ausgebildet ist,
**dadurch gekennzeichnet,**
**dass** der jeweilige Referenzsensor (11, 11' ... 11ⁿ) mit der Auswerteeinrichtung (4) elektrisch verbunden ist, dass zwei Referenzsensoren (11, ... 11ⁿ) den Schaltsensor (5) paarweise umschließen, dass die Paare von Referenzsensoren (11, ... 11ⁿ) an zwei, vorzugsweise diagonal gegenüberliegenden Positionen (13) voneinander getrennt sind, dass mindestens ein weiteres Paar von Referenzsensoren (11, ... 11ⁿ) um das erste Paar von Referenzsensoren (11, ... 11ⁿ) angeordnet ist, dass mittels der Auswerteeinrichtung (4) feststellbar ist, in welcher Reihenfolge das elektrische Feld (12, ... 12ⁿ) des jeweiligen Referenzsensors (11, ... 11ⁿ) und des Schaltsensors (5) auf der Schaltfläche (7) verändert ist und dass durch die Auswerteeinrichtung (4) die Betätigung des Schaltsensors (5) in Abhängigkeit von der Kapazitätsveränderung der Referenzsensoren (11, ... 11ⁿ) aktiviert oder gesperrt ist.

2. Kapazitive Taste nach Anspruch 1, **dadurch gekennzeichnet,**
**dass** der Schaltsensor (5) und die Referenzsensoren (11, ... 11ⁿ) als Schaltflächen ausgebildet sind, durch die jeweils eine Kapazität (9) bzw. (11, ... 11ⁿ) gebildet ist, dessen Flächenausdehnung an die Fläche des Schaltsensors (5) bzw. der Referenzsensoren (11, ... 11ⁿ) angepasst ist und dass die Auswerteeinrichtung (4) als integrierter Schaltkreis ausgestaltet ist.

3. Kapazitive Taste nach Anspruch 1 oder 2, **dadurch gekennzeichnet,**
**dass** der Abstand jedes Referenzsensors (11, ... 11ⁿ) zu dem Schaltsensor (5) unterschiedlich groß bemessen, konstant ist oder dass mindestens zwei der Referenzsensoren (11, 11' ... 11ⁿ) mit einem identischen Abstand zu dem Schaltsensor angeordnet sind.

4. Kapazitive Taste nach einem der vorgenannten Ansprüche, **dadurch gekennzeichnet,**
**dass** die Außenkontur des Schaltsensors (5) rechteckförmig, rund oder elliptisch ausgebildet ist und dass die Außenkonturen des jeweiligen Referenzsensors (11, ... 11ⁿ) an die Außenkontur des Schaltsensors (5) angepasst sind.

5. Kapazitive Taste nach einem der vorgenannten Ansprüche, **dadurch gekennzeichnet,**
**dass** um den äußersten Referenzsensor (11) ein Metallring (15) mit einem definierten Potential angebracht ist, durch die das elektrische Feld (12) der Referenzsensoren (11) beeinflusst ist.

6. Kapazitive Taste nach einem der vorgenannten Ansprüche, **dadurch gekennzeichnet,**
**dass** die Breiten oder Flächen der Referenzsensoren (11, ... 11ⁿ) gleich groß oder zueinander unterschiedlich ausgebildet sind.

## Claims

1. A capacitive button (1) for generating a switching signal that can be evaluated electrically,
- with a covering plate (6) consisting in particular of glass or a material which does not conduct electricity and by means of which a switching surface (7) accessible from the outside is created,
- with an energised switching sensor (5) arranged on a carrier plate or circuit board (3) or attached to the inside of the covering plate (6) which is opposite to the switching surface (7), by means of which an electrical field (9) acting on the switching surface (7) of the covering plate (6) is generated,
- with an evaluation device (4) that is electrically connected to the switching sensor (5) for detecting the changes in capacitance within the electrical field (9) on the switching surface (7),
- with at least one reference sensor (11, 11' ... 11ⁿ) enclosing the switching sensor (5) in whole or in part, in which case the reference sensor is energised and is located at a specified distance from the external periphery of the switching sensor (5), and by means of which an independent capacitance is propagated within an electrical field (12, 12', ... 12"),
**characterised in that**,
the particular reference sensor (11, 11' ... 11ⁿ) is electrically connected to the evaluation device (4), that two reference sensors (11 ... 11ⁿ) form a pair enclosing the switching sensor (5), that the pairs of reference sensors (11 ... 11ⁿ) are separated from one another at two positions (13) which are preferably diagonally opposite to one another, that at least one further pair of reference sensors (11 ... 11ⁿ) is arranged around the first pair of reference sensors (11 ... 11ⁿ), that the evaluation device (4) makes it possible to determine the sequence in which the electrical field (12 ... 12ⁿ) of the particular reference sensor (11 ... 11ⁿ) and the switching sensor (5) is changed on the switching surface (7) and that the evaluation device (4) activates or blocks the actuation of the switching sensor (5) depending on the capacitance change of the reference sensors (11 ... 11ⁿ).

2. The capacitive button in accordance with Claim 1,
**characterised in that**,
the switching sensor (5) and the reference sensors (11 ... 11ⁿ) are configured as switching surfaces by means of which in each case a capacitance (9) or (11 ... 11ⁿ) is formed, the surface extent of which is adapted to the surface area of the switching sensor (5) or the reference sensors (11 ... 11ⁿ) and that the evaluation device (4) is configured as an integrated circuit.

3. The capacitive button in accordance with Claim 1 or 2,
**characterised in that**,
the distance of each reference sensor (11 ... 11ⁿ) from the switching sensor (5) is different in magnitude, is constant or that at least two of the reference sensors (11 ... 11ⁿ) are arranged at an identical distance from the switching sensor.

4. The capacitive button in accordance with one of the aforementioned claims,
**characterised in that**,
the external contour of the switching sensor (5) is rectangular, round or elliptical in configuration and that the external contours of the particular reference sensor (11 ... 11ⁿ) are adapted to the external contour of the switching sensor (5).

5. The capacitive button in accordance with one of the aforementioned claims,
**characterised in that**,
a metal ring (15) with a defined potential is attached around the outermost reference sensor (11), by means of which the electrical field (12) of the reference sensors (11) is influenced.

6. The capacitive button in accordance with one of the aforementioned claims,
**characterised in that**,
the widths or surface areas of the reference sensors (11 ... 11ⁿ) are configured so as to be equal in magnitude or to differ in relation to one another.

## Revendications

1. Touche capacitive (1) servant à la génération d'un signal de commande électriquement utilisable,
- avec une plaque de recouvrement (6) réalisée de préférence en verre ou en un matériau non électroconducteur et qui forme une surface de commande (7) accessible de l'extérieur,
- avec un capteur de commande (5) sous tension, disposé sur une platine de support ou sur une carte imprimé (3) ou sur la face intérieure de la plaque de recouvrement (6), opposée à la surface de commande (7), qui génère en champ électrique (9) agissant sur la surface de commande (7) de la plaque de recouvrement (6),
- avec un équipement d'évaluation (4) raccordé électriquement au capteur de commande (5) pour la reconnaissance des changements de capacité à l'intérieur du champ électrique (9) sur la surface de commande (7),
- avec au moins un capteur de référence (11, 11' ... 11ⁿ) enveloppant entièrement ou partiellement le capteur de commande (5), qui est sous tension et qui se trouve à une distance définie du pourtour extérieur du capteur de commande (5), et qui forme respectivement une capacité individuelle à l'intérieur du champ électrique (12, 12' ... 12ⁿ),
**caractérisée en ce que**
le capteur de référence respectif (11, 11' ... 11ⁿ) est raccordé électriquement à l'équipement d'évaluation (4), que deux paires de capteurs de référence (11, ... 11ⁿ) entourent le capteur de commande (5), que les paires de capteurs de référence (11, ... 11ⁿ) sont séparées les unes des autres en deux positions (13) de préférence diamétralement opposées, qu'au moins une autre paire de capteurs de référence (11, ... 11ⁿ) est disposée autour de la première paire de capteurs de référence (11, ... 11ⁿ), que l'équipement d'évaluation (4) permet d'identifier dans quel ordre le champ électrique (12, ... 12") du capteur de référence respectif (11, ... 11ⁿ) et du capteur de commande (5) sur la surface de commande (7) s'est changé, et que l'actionnement du capteur de commande (5) en dépendance du changement de capacité des capteurs de référence (11, ... 11ⁿ) est activé ou bloqué par l'équipement d'évaluation (4) (11, ... 11ⁿ).

2. Touche capacitive (1) d'après la revendication 1,
**caractérisée en ce que**
le capteur de commande (5) et les capteurs de référence (11, ... 11ⁿ) sont conçus en tant que faces de commutation assurant respectivement une capacité (9) ou (11, ... 11ⁿ) dont l'extension de surface est adaptée à la surface du capteur de commande (5) ou des capteurs de référence (11, ... 11ⁿ), et que l'équipement d'évaluation (4) est formé par un circuit intégré.

3. Touche capacitive (1) d'après les revendications 1 ou 2,
**caractérisée en ce que**
la distance entre chaque capteur de référence (11, ... 11ⁿ) et le capteur de commande (5) est différente, constante ou qu'au moins deux des capteurs de référence (11, 11' ... 11ⁿ) sont disposés à une distance identique du capteur de commande (5).

4. Touche capacitive (1) d'après une des revendications précédentes,
**caractérisée en ce que**
le contour extérieur du capteur de commande (5) est rectangulaire, rond ou elliptique et que les contours extérieurs du capteur de référence respectif (11,... 11ⁿ) est adapté au contour extérieur du capteur de commande (5).

5. Touche capacitive (1) d'après une des revendications précédentes,
**caractérisée en ce que**,
autour du capteur de référence extérieur (11), il est monté un anneau métallique (15) avec un potentiel défini, qui assure l'influence sur le champ électrique (12) des capteurs de référence extérieurs (11).

6. Touche capacitive (1) d'après une des revendications précédentes,
**caractérisée en ce que**
les largeurs ou les surfaces des capteurs de référence (11, ... 11ⁿ) sont identiques ou différentes les unes par rapport aux autres.
